# EUROPÄISCHE PATENTSCHRIFT

(11) **EP 0 302 189 B1**
(45) Veröffentlichungstag und Bekanntmachung des Hinweises auf die Patenterteilung: **20.07.1994**
(21) Anmeldenummer: 88108291.1
(22) Anmeldetag: 25.05.1988
(51) Int. Cl.: G09F 9/35, G02F 1/133, H04M 1/02

(54) **Anzeigevorrichtung mit einer Flüssigkeitskristallanzeige**
Display device with liquid crystal display cells
Dispositif d'affichage avec affichage à cristaux liquides

(30) Priorität: 07.08.1987 DE 3726225
(43) Veröffentlichungstag der Anmeldung: 08.02.1989
(73) Patentinhaber: TELENORMA GMBH, 60326 Frankfurt am Main (DE)
(72) Erfinder: Ogorczyk, Bernd, Dipl.-Ing., D-6367 Karben 1 (DE)

(56) Entgegenhaltungen:
- EP-A- 0 075 213
- DE-A- 3 144 535
- DE-A- 3 408 176
- DE-A- 3 512 229
- DE-U- 8 321 095
- DE-U- 8 620 373

## Beschreibung

Die Erfindung betrifft eine Anzeigevorrichtung, insbesondere für ein Endgerät einer Fernmeldevermittlungsanlage, bei welcher eine Flüssigkristallanzeigevorrichtung in einem Kunststoffkörper aufgenommen und von diesem seitlich federnd gehalten wird, indem dieselbe in der einen Achse auf einer Seite durch an dem Kunststoffkörper angebrachte Federn gegen einen Anschlag gedrückt wird, wobei an der Unterseite des Kunststoffkörpers eine mit den der Flüssigkristallanzeigevorrichtung zugeordneten Bauelementen bestückte Leiterplatte angebracht ist und der Kunststoffkörper stiftförmige Justierbolzen trägt, welche in Bohrungen der Leiterplatte eingreifen, zur elektrischen Verbindung der Flüssigkristallanzeigevorrichtung mit der Leiterplatte streifenförmige, aus elastischem Material bestehende Verbinder vorhanden sind und die Anzeigevorrichtung an dem Gehäuse des Endgeräts befestigbar ist.

Eine derartige Anzeigevorrichtung ist bereits bekannt. So wird in der DE-PS 31 44 535 eine Anzeigeeinrichtung mit Flüssigkristallanzeige beschrieben, bei welcher die Flüssigkristallanzeigevorrichtung seitlich in den Kunststoffkörper eingeschoben wird,welche in der Endlage durch eine hinter deren Ende rastende Feder gehalten wird. Die Feder drückt dabei die Anzeigevorrichtung gegen einen Anschlag.

Je nach Ausführung und Einsatzzweck weisen Flüssigkristallanzeigevorrichtungen eine Vielzahl von Anschlußpunkten auf. Soll die Flüssigkristallanzeigevorrichtung auch zur Anzeige von Ziffern dienen, so werden hierzu die bekannten Siebensegmentanzeigen benutzt, die pro Segment einen elektrischen Anschluß benötigen. Für die Anzeige einer Vielzahl von Ziffernstellen steigt der Bedarf in elektrischen Anschlüssen stark an, so daß in Folge der Abmessungen der Flüssigkrsitallanzeigevorrichtung der Zahl der unterzubringenden Anschlußpunkte Grenzen gesetzt sind. Hierbei ist auch noch zu berücksichtigen, daß die äußeren Abmessungen der in der Regel aus Glasscheiben zusammengesetzten Flüssigkristallanzeigevorrichtungen relativ große Toleranzen aufweisen. Aus der DE-A-3 408 176 ist eine andere Vorrichtung bekannt in der die Flüssigkristallanzeige seitlich durch eine Feder gegen einen Anschlag gedrückt wird. Darüberhinaus werden im Oberteil des Gehaüses weitere Federn vorgesehen, welche die Flüssigkristallanzeige gegen den Unterteil drücken.

Die Aufgabe der Erfindung besteht nun darin, eine Anzeigevorrichtung mit einer Flüssigkristallanzeige derart auszubilden, daß für eine Vielzahl von Kontaktstellen unter Berücksichtigung der großen Toleranzen der Flüssigkristallanzeige eine sichere Kontaktgabe gewährleistet ist und darüber hinaus auch die bekannte Anzeigevorrichtung weiter zu verbessern.

Diese Aufgabe wird dadurch gelöst, daß an dem Kunststoffkörper in der anderen Achse weitere Federn vorgesehen sind, welche die Flüssigkeistsanzeigevorrichtung auf der anderen Seite gegen einen Anschlag drückt.

Damit wird sowohl in der x-Achse als auch in der y-Achse die Flüssigkristallanzeigevorrichtung durch Federn gegen gegenüberliegende Anschläge gedrückt, wodurch eine eindeutige Positionierung derselben gewährleistet ist.

Eine Weiterbildung der Erfindung besteht darin, daß der Kunststoffkörper an zwei gegenüberliegenden Seiten Rastfedern aufweist, welche in die Leiterplatte einrasten.

Im Gegensatz zum bekannten Stand der Technik, wo die Verbindung von Kunststoffkörper und Leiterplatte mittels Schrauben erfolgt, wird gemäß der vorliegenden Erfindung die Verbindung zwischen Kunststoffkörper und Leiterplatte durch Rastfedern vorgenommen. Besonders Vorteilhaft ist dabei, wenn auf der der Leiterplatte abgewandten Seite der Rastfedern am Kunststoffkörper Taschen angebracht sind, welche Sicherungslaschen des Gehäuses des Endgeräts aufnehmen. Hierdurch werden die Rastfedern in der eingerasteten Position gehalten, so daß eine erschütterungsfreie Befestigung von Kunststoffkörper und Leiterplatte gewährleistet ist.

Weitere Vorteile ergeben sich aus den Unteransprüchen.

Die Erfindung wird anhand eines Ausführungsbeispiels näher erläutert, welches in der Zeichnung dargestellt ist. Es zeigt:

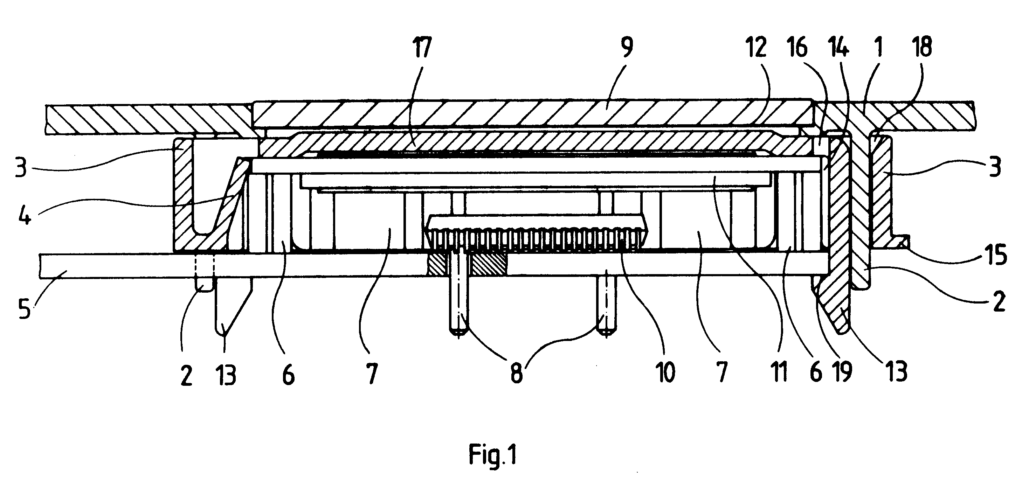

- Fig. 1: einen Schnitt durch die in das Gehäuses eines Endgeräts eingesetzte Anzeigevorrichtung,

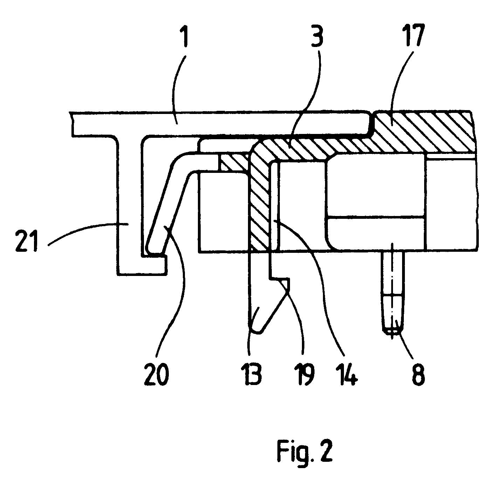

- Fig. 2: einen Teilschnitt durch den Kunststoffkörper und

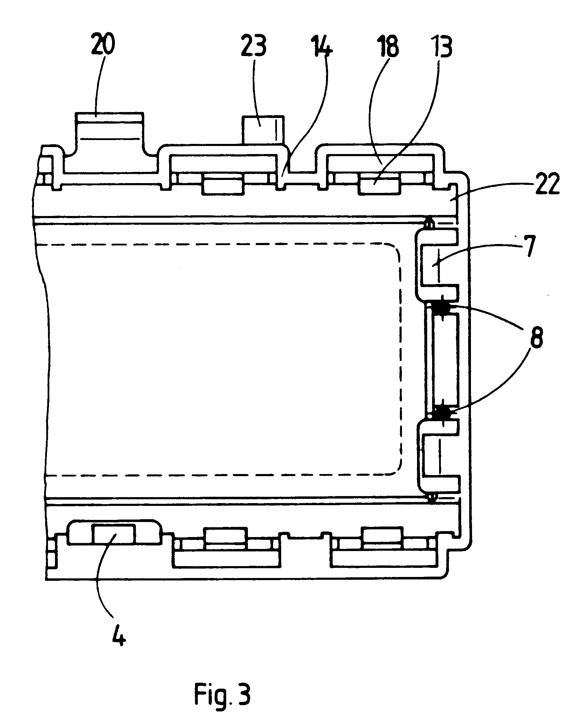

- Fig. 3: eine Draufsicht auf den Kunststoffkörper.

Der aus einem transparenten Material hergestellte Kunststoffkörper 3 nimmt die Flüssigkristallanzeigevorrichtung 11 auf, die in der x-Achse durch Federn 7 gegen einen nicht gezeigten Anschlag und in der y-Achse durch Federn 4 gegen den Anschlag 14 gedrückt wird. Federn und Anschläge sind am Kunststoffkörper 3 angebracht. Zwischen der Flüssigkristallanzeigevorrichtung 11 und der Leiterplatte 5 sind zwei am oberen und unteren Rand derselben in der x-Achse verlaufende elektrische Verbinder 6 bestehend aus einem elastischen Material angebracht. Der elektrische Kontakt zwischen den an der Flüssigkristallanzeigevorrichtung 11 angebrachten und den auf der Leiterplatte 5 mit diesen fluchtend angebrachten Kontaktflächen erfolgt durch Einrasten der Rastfedern 13 des die Flüssigkristallanzeigevorrichtung 11 umgreifenden Kunststoffkörpers 3 in die Leiterplatte 5. Zur Führung dienen am Kunststoffkörper 3 angebrachte Justierbolzen 8, welche durch entsprechende Öffnungen der Leiterplatte 5 ragen. Im endgültig eingesetzten Zustand der Anzeigevorrichtung in das Gehäuse des Endgeräts ragen an demselben angebrachte Sicherungslaschen 2 durch auf der der Leiterplatte 5 abgewandten Seite der Rastfedern 13 am Kunststoffkörper 3 angebrachte Taschen hineinragen und somit die Rastnasen 13 in der eingerasteten Position verriegeln.

Eine andere Möglichkeit der Verbindung zwischen Kunststoffkörper 3 und Leiterplatte 5 kann darin bestehen, daß auf beiden Seiten in Richtung der x-Achse Zentrierzapfen 8 angebracht sind, welche nach Beendigung der Montage durch Ultraschall erhitzt und zusammengepreßt werden, so daß quasi eine Nietverbindung entsteht.

Der aus einem transparentem Material hergestellte Kunststoffkörper 3 weist eine Abdeckung 17 über der Flüssigkristallanzeigevorrichtung auf, welche derart ausgebildet sein kann, daß diese in eine entsprechende Öffnung des Gehäuses 1 des Endgeräts paßt und mit dessen Oberfläche abschließt. Eine andere Lösung kann darin bestehen, daß die betreffende Öffnung im Gehäuse 1 durch eine besondere Gehäuseabdeckung 9 geschlossen wird, wobei die Möglichkeit besteht, an der Unterseite der Abdeckung 9 eine Blende 12 anzubringen, um so den Einbau verschiedenartiger Anzeigevorrichtungen mit unterschiedlichen Sichtfeld Abmessungen einsetzen zu können.

Zur Bildung der Rastennasen 19 der Rastfedern 13 durch einen Spritzgießvorgang sind Öffnungen 16 vorhanden, durch welche die Stempel des Werkzeuges zurückgezogen werden. Hierdurch kann der Kunststoffkörper 3 mit einem schieberfreien Spritzgleßwerkzeug hergestellt werden.

Der Kunststoffkörper 3 ist an einer oder mehreren Seiten mit Nasen 20 versehen, welche in an der Unterseite des Gehäuses 1 des Endgeräts angebrachte Vorsprünge 21 einrasten und auf diese Weise die Anzeigevorrichtung gegen das Gehäuse pressen. Die beiden elektrischen Verbinder 6 liegen an der Innenseite des Kunststoffkörpers 3 und zwar an den Anschlägen 14 an, die auf beiden Längsseiten in Richtung der x-Achse angebracht sind. Die beiden Verbinder 6 ragen an beiden Enden über die Glasplatte der Flüssigkristallanzeigevorrichtung hinaus und enden in den Taschen 22 des Kunststoffkörpers 3.

Durch an der einen Außenseite angebrachte Nasen 15 kann ein parellel zur Oberseite des Gehäuses 1 angebrachter Ausweisleser gehalten werden, dessen elektrischer Anschluß ebenfalls an der Leiterplatte 5 angebracht sein kann. Die Bauteileseite der Leiterplatte 5 ist die der Flüssigkristallanzeigevorrichtung abgewandte Seite. Unterhalb der Flüssigkristallanzeigevorrichtung, d.h. auf der Lötseite können oberflächenmontierte elektronische Bauteile 10 angebracht sein, beispielsweise die Treiber für die Flüssigkristallanzeigevorrichtung.

## Patentansprüche

1. Anzeigevorrichtung, insbesondere für ein Endgerät einer Fernmeldevermittlungsanlage, bei welcher eine Flüssigkristallanzeigevorrichtung (11) in einem Kunststoffkörper (3) aufgenommen und von diesem seitlich federnd gehalten wird, indem dieselbe in der einen Achse auf der einen Seite durch an dem Kunststoffkörper (3) angebrachte Federn (7) gegen einen Anschlag gedrückt wird, wobei an der Unterseite des Kunststoffkörpers eine mit den Flüssigkristallanzeigevorrichtung (11) zugeordneten Bauelementen bestückte Leiterplatte (5) angebracht ist, und der Kunststoffkörper (3) stiftförmige Justierbolzen (8) trägt, welche in Bohrungen der Leiterplatte (5) eingreifen, zur elektrischen Verbindung der Flüssigkristallanzeigevorrichtung (11) mit der Leiterplatte (5) streifenförmige, aus elastischem Material bestehende Verbinder (6) vorhanden sind und die Anzeigevorrichtung an dem Gehäuse des Endgeräts befestigbar ist,
**dadurch gekennzeichnet,**
daß an dem Kunststoffkörper (3) in der anderen Achse weitere Federn (4) vorgesehen sind, welche die Flüssigkristallanzeigevorrichtung (11) auf der anderen Seite gegen einen weiteren Anschlag (14) des Kunststoffkörpers (3) drücken.

2. Anzeigevorrichtung nach Anspruch 1,
dadurch gekennzeichnet,
daß zumindest ein Teil der Justierbolzen (8) zur Befestigung des Kunststoffkörpers (3) mit der Leiterplatte (5) dient.

3. Anzeigevorrichtung nach Anspruch 1,
dadurch gekennzeichnet,
daß der Kunststoffkörper (3) an zwei gegenüberliegenden Seiten Rastfedern (13) aufweist, welche in die Leiterplatte (5) einrasten.

4. Anzeigevorrichtung nach Anspruch 1 oder 3,
dadurch gekennzeichnet,
daß auf der der Leiterplatte (5) abgewandten Seite der Rastfedern (13) am Kunststoffkörper (3) Taschen (18) angebracht sind, welche Sicherungslaschen (2) des Gehäuses (1) des Endgeräts aufnehmen.

5. Anzeigevorrichtung nach einem der Ansprüche 1 bis 4,
dadurch gekennzeichnet,
daß der Kunststoffkörper (3) aus einem transparenten Material hergestellt ist.

6. Anzeigevorrichtung nach einem der Ansprüche 1 bis 5,
dadurch gekennzeichnet,
daß der Kunststoffkörper (3) eine Abdeckung (17) aufweist, welche über der Flüssigkristallanzeige (11) angebracht ist.

7. Anzeigevorrichtung nach einem der Ansprüche 1 bis 6,
dadurch gekennzeichnet,
daß die Abdeckung (17) durch eine entsprechende Öffnung des Gehäuses (1) des Endgeräts ragt und mit dessen Oberfläche bündig abschließt.

8. Anzeigevorrichtung nach einem der Ansprüche 3 bis 7,
dadurch gekennzeichnet,
daß der Kunststoffkörper (3) Öffnungen (16) aufweist, durch welche die Stempel des Spritzgießwerkzeug zur Formung der Rastnasen (19) der Rastfedern (13) ragen.

9. Anzeigevorrichtung nach einem der Ansprüche 1 bis 8,
dadurch gekennzeichnet,
daß der Kunststoffkörper Nasen (20) aufweist, welche in am Gehäuse (1) des Endgeräts angebrachte Vorsprünge (21) einrasten und die Anzeigevorrichtung an der Gehäuseunterseite des Gehäuses (1) halten.

10. Anzeigevorrichtung nach einem der Ansprüche 1 bis 9,
dadurch gekennzeichnet,
daß die elektrischen Verbinder (6) an den zwischen den Rastnasten (13) angebrachten Anschlägen (14) anliegen.

11. Anzeigevorrichtung nach einem der Ansprüche 1 bis 10,
dadurch gekennzeichnet,
daß die elektrischen Verbinder (6) mit ihren beiden Enden von jeweils einer Tasche (22) des Kunststoffkörpers (3) aufgenommen werden.

12. Anzeigevorrichtung für einen Fernsprechapparat mit einem parallel zur Oberseite angebrachten Kartenleser, nach einem der Ansprüche 1 bis 11,
dadurch gekennzeichnet,
daß der Kunststoffkörper (3) Haltenasen (23) für den Kartenleser aufweist.

13. Anzeigevorrichtung nach Anspruch 12,
dadurch gekennzeichnet,
daß der Stecker zum Anschluß des Ausweislesers an der Leiterplatte (5) angebracht ist.

## Claims

1. Display device especially for a terminal apparatus of a telecommunications exchange, in which a liquid crystal display device (11) is received in a synthetic material body (3) and is resiliently held at the side by this, in that the same is pressed in one axis on one side against an abutment by springs (7) mounted at the synthetic material body (3), wherein a circuitboard (5) equipped with components associated with the liquid crystal display device (11) is mounted at the underside of the synthetic material body, and the synthetic material body (3) carries pin-shaped registration bolts (8), which engage in bores of the circuitboard (5), for the electrical connection of the liquid crystal display device (11) with the circuitboard (5), striplike connectors (6) consisting of resilient material are present and the display device is fastenable to the housing of the terminal apparatus, characterised thereby that further springs (4), which press the liquid crystal display device (11) on the other side against a further abutment (14) of the synthetic material body (3), are provided at the synthetic material body (3) in the other axis.

2. Display device according to claim 1, characterised thereby that at least a part of the registration bolts (8) serve for the fastening of the synthetic material body (3) with the circuitboard (5).

3. Display device according to claim 1, characterised thereby that the synthetic material body (3) has detent springs (13), which detent in the circuitboard (5), at two oppositely disposed sides.

4. Display device according to claim 1 or 3, characterised thereby that pockets (18), which receive securing tongues (2) of the housing (1) of the terminal apparatus, are mounted at the synthetic material body (3) on the side of the detent springs (13) remote from the circuitboard (5).

5. Display device according to one of claims 1 to 4, characterised thereby that the synthetic material body (3) is made of a transparent material.

6. Display device according to one of claims 1 to 5, characterised thereby that the synthetic material body (3) has a cover (17), which is mounted over the liquid crystal display device (11).

7. Display device according to one of claims 1 to 6, characterised thereby that the cover (17) projects through a corresponding opening of the housing (1) of the terminal apparatus and closes off flushly with the surface thereof.

8. Display device according to one of claims 3 to 17, characterised thereby that the synthetic material body (3) has openings (16) through which the dies of the injection moulding tool project for the formation of the detent lugs (19) of the detent springs (13).

9. Display device according to one of claims 1 to 8, characterised thereby that the synthetic material body has lugs (20) which detent in projections (21) mounted at the housing (1) of the terminal apparatus and retain the display device at the housing underside of the housing (1).

10. Display device according to one of claims 1 to 9, characterised thereby that the electrical connectors (6) bear against the abutments (14) mounted between the detent lugs (13).

11. Display device according to one of claims 1 to 10, characterised thereby that the electrical connectors (6) are received at their two ends by a respective pocket (22) of the synthetic material body (3).

12. Display device for a telephone apparatus with a card reader mounted parallel to the upper side, according to one of claims 1 to 11, characterised thereby that the synthetic material body (3) has retaining lugs (23) for the card reader.

13. Display device according to claim 12, characterised thereby that the plug for connection to the identification reader is mounted at the circuitboard (5).

## Revendications

1. Dispositif d'affichage, notamment pour un terminal d'une installation de commutation téléphonique, dans lequel un dispositif d'affichage à cristal liquide (11) est logé dans un corps en matière plastique (3) et retenu latéralement de façon élastique par ce corps, en étant repoussé contre une butée, suivant un axe et sur un côté, par des ressorts (7) montés sur le corps en matière plastique (3), et dans lequel sur la face inférieure du corps en matière plastique est disposée une plaquette à circuits imprimés (5) équipée de composants associés au dispositif d'affichage à cristal liquide (11), le corps en matière plastique (3) comportant des goujons d'ajustement en forme de tiges (8) qui s'engagent dans des perçages de la plaquette à circuits imprimés (5), des connecteurs en forme de bandes (6) réalisés en un matériau élastique sont prévus pour établir la liaison électrique du dispositif d'affichage à cristal liquide (11) avec la plaquette à circuits imprimés (5), et le dispositif d'affichage peut être fixé sur le boîtier du terminal,
caractérisé en ce
que sur le corps en matière plastique (3) sont prévus, sur l'autre axe, d'autres ressorts (4), qui repoussent le dispositif d'affichage à cristal liquide (11), sur l'autre côté, contre une autre butée (14) du corps en matière plastique (3).

2. Dispositif d'affichage selon la revendication 1, caractérisé en ce qu'au moins une partie des goujons d'ajustement (8) sert à fixer le corps en matière plastique (3) à une plaquette à circuits imprimés (5).

3. Dispositif d'affichage selon la revendication 1, caractérisé en ce que le corps en matière plastique (3) possède, sur deux côtés opposés, des ressorts d'encliquetage (13), qui s'encliquettent dans la plaquette à circuits imprimés (5).

4. Dispositif d'affichage selon la revendication 1 ou 3, caractérisé en ce que sur le côté des ressorts d'encliquetage (13), tourné à l'opposé de la plaquette à circuits imprimés (5), sont formés, dans le corps en matière plastique (3), des logements (18), qui reçoivent des pattes de fixation (2) du boîtier (1) du terminal.

5. Dispositif d'affichage selon l'une des revendications 1 à 4, caractérisé en ce que le corps en matière plastique (3) est réalisé en un matériau transparent.

6. Dispositif d'affichage selon l'une des revendications 1 à 5, caractérisé en ce que le corps en matière plastique (3) possède un capot (17), qui est disposé au-dessus du dispositif d'affichage à cristal liquide (11).

7. Dispositif d'affichage selon l'une des revendications 1 à 6, caractérisé en ce que le capot (17) pénètre dans une ouverture correspondante du boîtier (1) du terminal et se termine de niveau avec la surface de ce dernier.

8. Dispositif d'affichage selon l'une des revendications 3 à 7, caractérisé en ce que le corps en matière plastique (3) possède des ouvertures (16), dans lesquelles pénètrent les poinçons de l'outil de moulage par injection pour la formation des becs d'encliquetage (19) des ressorts d'encliquetage (13).

9. Dispositif d'affichage selon l'une des revendications 1 à 8, caractérisé en ce que le corps en matière plastique possède des becs (20), qui s'encliquettent dans des parties saillantes (21) situées sur le boîtier (1) du terminal et retiennent le dispositif d'affichage sur la face inférieure du boîtier (1).

10. Dispositif d'affichage selon l'une des revendications 1 à 9, caractérisé en ce que les connecteurs électriques (6) s'appliquent contre les butées 14, qui sont disposées entre les ergots d'encliquetage (13).

11. Dispositif d'affichage selon l'une des revendications 1 à 10, caractérisé en ce que les connecteurs électriques (6) sont logés, par leurs deux extrémités, dans des logements respectifs (22) du corps en matière plastique (3).

12. Dispositif d'affichage pour un poste téléphonique comportant un lecteur de cartes disposé parallèlement à la face supérieure selon l'une des revendications 1 à 11, caractérisé en ce que le corps en matière plastique (3) possède des ergots de retenue (23) pour le lecteur de cartes.

13. Dispositif d'affichage selon la revendication 12, caractérisé en ce que le connecteur est installé pour raccorder le lecteur de cartes d'identité à la plaquette à circuits imprimés (5).
